# EUROPÄISCHE PATENTSCHRIFT

(11) **EP 0 875 766 B1**
(45) Veröffentlichungstag und Bekanntmachung des Hinweises auf die Patenterteilung: **26.07.2006**
(21) Anmeldenummer: 98106197.1
(22) Anmeldetag: 04.04.1998
(51) Int. Cl.: G01R 31/327, G01R 31/02, G01R 31/04, G08B 29/04, B60R 16/02

(54) **Schaltungsanordnung und Verfahren zur Überprüfung der Kontaktierung eines Schalters oder Tasters**
Circuit device and method for inspecting the connection of a switch or push button
Circuit et procédure d'inspection de raccordement d'un interrupteur ou d'un bouton-poussoir

(30) Priorität: 29.04.1997 DE 19718041
(43) Veröffentlichungstag der Anmeldung: 04.11.1998
(73) Patentinhaber: DaimlerChrysler AG, 70567 Stuttgart (DE)
(72) Erfinder: Tislaric, Darko, 71063 Sindelfingen (DE)

(56) Entgegenhaltungen:
- EP-A- 0 615 267
- DE-C- 4 240 447
- GB-A- 2 159 285
- PATENT ABSTRACTS OF JAPAN vol. 017, no. 590 (P-1635), 27. Oktober 1993 (1993-10-27) -& JP 05 174282 A (MATSUSHITA ELECTRIC WORKS LTD), 13. Juli 1993 (1993-07-13)

## Beschreibung

Die vorliegende Erfindung betrifft eine Schaltungsanordnung zur Überprüfung der Kontaktierung eines Schalters oder Tasters nach einem der Patentansprüche 1, 2, 3 oder 4. Ebenso betrifft die Erfindung ein Verfahren zur Überprüfung der Kontaktierung eines Schalters oder Tasters nach Anspruch 5.

Es ist bekannt, anstelle von Leistungsschaltern Schalter zu verwenden, deren Schaltstellung über einen Controller eingelesen wird. Diese Schalter werden mit einem Eingang des Controllers verbunden, der auch als I/O-Port ausgebildet sein kann. Durch die Belegung dieses Ports mit dem Schalter wird dieser I/O-Port nur als Eingang verwendet. Weiterhin ist es bekannt, beispielsweise analoge Schalter einem Eingang eines Controllers zuzuführen, der als A/D-Wandler ausgebildet ist. Wenn überprüft werden soll, ob alle Schalter einer vorgegebenen Gerätespezifikation eingebaut worden sind und ob alle Schalter auch ordnungsgemäß kontaktiert sind und ordnungsgemäß funktionieren, werden diese Schalter manuell getestet. Dabei wird der Prüfer durch interaktive Prüfprogramme geleitet, um die Überprüfung aller Schalter sicherzustellen.

Insbesondere im produzierenden Gewerbe wie zum Beispiel der Automobilindustrie oder der Elektronikindustrie tritt öfter die Anforderung auf, bei fertig produzierten Produkten zu überprüfen, ob alle Schalter gemäß einer vorgegebenen Produktspezifikation in das Produkt eingebaut sind.

Es ist weiterhin eine Schaltungsanordnung bekannt (DE 37 24 926 A1), bei der ein im Ruhezustand offener Schalter oder Sensor überprüft wird, indem zu diesem Schalter oder Sensor ein Widerstand parallel geschaltet wird. Anhand sich unterschiedlich einstellender Spannungspegel aufgrund der Widerstandsverhältnisse zu anderen parallel und in Serie geschalteten Widerständen können verschiedene Kontaktierungsfehler bzw. Funktionsstörungen des Schalters oder Sensors erkannt werden. Um einen Dauerstrom über diesen Widerstand zu vermeiden, ist in Serie zu diesem Widerstand ein steuerbarer Schalter geschaltet, der nur dann durchgeschaltet wird, wenn eine Überprüfung stattfinden soll.

Aus der deutschen Patentschrift DE 4240447 C1 ist eine Schaltungsanordnung und ein Verfahren bekannt, mit dem es möglich ist, die Anzahl der an eine Versorgungsleitung angeschlossenen Steuergeräte zu ermitteln. Die Steuergeräte kodieren hierbei mit ihren Anschlussimpedanzen. Gemessen wird die Gesamtimpedanz aller angeschlossenen Steuergeräte und diese Gesamtimpedanz wird in einer Tabelle mit den Impedanzen der möglichen Steuergerätekonfigurationen verglichen. Stimmt die gemessene Gesamtimpedanz mit einer Impedanz aus der Tabelle überein, ist die zugehörige Steuergerätekonfiguration ermittelt. Kann keine Konfiguration ermittelt werden, deutet dies auf einen Fehler hin.

Aus der gattungsbildenden Japanischen Patentanmeldung JP A 05174282 ist eine Schaltungsanordnung zur Überprüfung der ordnungsgemäßen Kontaktierung eines Schalters oder Tasters in einer gleichspannungsversorgten Schaltung bekannt. Der zu überprüfende Schalter ist zumindest zeitweise mit einem Port einer Überwachungsschaltung verbunden. Die Überwachungsschaltung enthält einen Mikroprozessor und Schalt- bzw. Erfassungsmittel, mit denen der Spannungsabfall an dem zu überprüfenden Schalter erfasst werden kann und im Mikroprozessor ausgewertet werden kann. Der zu überprüfende Schalter hat parallel zu seiner Schaltstrecke einen Kondensator. Durch eine zeitliche Analyse des Spannungsverlaufs an dem zu prüfenden Schalter kann auf dessen Vorhandensein und dessen Schaltstellung geschlossen werden.

Es ist Aufgabe der vorliegenden Erfindung, die Überprüfung der ordnungsgemäßen Kontaktierung eines Schalters oder Tasters unabhängig von dessen Schaltstellung zu ermöglichen.

Diese Aufgabe wird durch eine Schaltungsanordnung gemäß den Ansprüchen 1 bzw. 2 sowie durch ein Prüfverfahren gemäß Anspruch 5 gelöst.

Diese Aufgabe wird gemäß Anspruch 1 gelöst durch eine Schaltungsanordnung zur Überprüfung der ordnungsgemäßen Kontaktierung eines Schalters oder Tasters in einer gleichspannungsversorgten Schaltung, der zumindest zeitweise mit wenigstens einem Eingang sowie zumindest zeitweise mit wenigstens einem Ausgang eines Controllers oder Mikroprozessors verbunden ist, wobei in der Schaltstrecke des Schalters oder Tasters eine Spulenanordnung angeordnet ist, und parallel zur Schaltstrecke des Schalters oder Tasters eine Kondensatoranordnung angeordnet ist.

Mit einer solchen Schaltungsanordnung kann die Kontaktierung eines Schalters oder Tasters in dessen betätigtem Zustand überprüft werden. Hierbei wird das Zeitverhalten des Signalpegels ausgewertet, nachdem der Signalpegel über den Ausgang des Controllers oder Mikroprozessors so geändert wurde, daß dieser Signalpegel dem Signalpegel bei einem betätigten Schalter oder Taster entspricht.

Dadurch ist eine Überprüfung vorteilhaft unabhängig davon möglich, ob der Schalter oder Taster betätigt wird. Es stellt sich dann auf eine Änderung des Signalpegels über den Ausgang des Controller oder Mikroprozessors immer ein bestimmtes Zeitverhalten des Signalpegels ein.

Durch diese Schaltungsanordnung kann der Test der Kontaktierung bzw. die Überprüfung ob der Schalter oder Taster überhaupt eingebaut ist, durchgeführt werden, ohne daß eine Betätigung des Tasters oder Schalters notwendig ist. Es wird damit also möglich, die Überprüfung der Kontaktierung selbsttätig durchzuführen.

Die Kondensatoranordnung kann beispielsweise aus einem einzigen Kondensator bestehen. Dieser Kondensator verhindert das Fließen eines Gleichstromes, wenn der Schalter oder Taster nicht betätigt wird. Es müssen also keine weiteren Maßnahmen (zum Beispiel die Trennung mittels eines steuerbaren Schalters) getroffen werden, um einen Dauerstrom und eine dadurch bedingte Entladung einer Batterie eines Kraftfahrzeuges zu vermeiden.

Der Schalter oder Taster kann beispielsweise einem I/O-Port zugeführt sein. Nach der Erfindung wird dieses Port dann nicht lediglich als Eingang verwendet, sondern es wird zwischen Eingang und Ausgang gewechselt, um für die Überprüfung Signalpegel zu ändern. Es ist auch möglich, den Schalter oder Taster mit unterschiedlichen Ports zu verbinden, von denen wenigstens eines ein Eingang und wenigstens ein anderes ein Ausgang ist.

Es kann dann das Zeitverhalten des Signalpegels nach einer Pegeländerung ausgewertet werden. Wegen des RC-Gliedes kommt es bei richtiger Kontaktierung zu einem verzögerten Anstieg des Signalpegels.

Weiterhin wird diese Aufgabe nach Anspruch 2 gelöst durch eine Schaltungsanordnung zur Überprüfung der ordnungsgemäßen Kontaktierung eines Schalters oder Tasters in einer gleichspannungsversorgten Schaltung, der zumindest zeitweise mit wenigstens einem Eingang sowie zumindest zeitweise mit wenigstens einem Ausgang eines Controllers oder Mikroprozessors verbunden ist, wobei der Schalter oder Taster als Wechselschalter oder Wechseltaster ausgebildet ist, dessen eine Schaltstrecke über eine Spulenanordnung mit einem bestimmten Potential verbindet und dessen andere Schaltstrecke über eine Kondensatoranordnung mit dem bestimmten Potential verbindet.

Gegenüber der Schaltungsanordnung nach Anspruch 1 besteht hier der Unterschied, daß der Schalter oder der Taster als Wechselschalter oder Wechseltaster ausgebildet sind. Dadurch kann vermieden werden, daß bei einem betätigten Schalter oder Taster ein abklingendes Schwingverhalten entsteht. Es stellt sich also immer nach einer gewissen Verzögerungszeit ein bestimmter Signalpegel ein.

Nach Anspruch 3 kann eine der vorgenannten Schaltungsanordnungen weitergebildet werden, indem Eingang und Ausgang des Controllers oder Mikroprozessors über ein I/O-Port realisiert sind.

Dabei müssen Schalter oder Taster vorteilhaft nur mit einem einzigen Anschluß des Controllers oder Mikroprozessors verbunden werden.

Nach Anspruch 4 kann eine der vorgenannten Schaltungsanordnungen weitergebildet werden, indem Eingang und Ausgang des Controllers oder Mikroprozessors verschieden und entsprechend zeitversetzt aktivierbar sind.

Dadurch ist es beispielsweise auch möglich, einen analogen Schalter zu überprüfen, der mit einem A/D-Wandler verbunden ist.

Weiterhin wird diese Aufgabe gelöst durch ein Verfahren nach Anspruch 5, bei dem zum Prüfen der ordnungsgemäßen Kontaktierung eines Schalters oder Tasters eine der vorgenannten Schaltungsanordnungen verwendet wird, wobei während des Betriebes bei einem erkannten Signalpegel, der auf eine Betätigung des Schalters oder Tasters zurückgeführt werden kann, über den Ausgang ein Signalpegel ausgegeben wird, der dem Signalpegel am Eingang bei einer ordnungsgemäßen Kontaktierung und einer Betätigung des Schalters oder Tasters entspricht, und anschließend der Ausgang deaktiviert wird und wobei aus dem dann anschließenden Zeitverhalten des Signalpegels darauf geschlossen wird, ob eine Betätigung des Schalters oder Tasters vorliegt.

Damit kann vorteilhaft eine Betätigung des Schalter oder Tasters von einer Fehlersituation wie eines Masseschlusses der Leitung unterschieden werden. Die Signalauswertung kann dadurch hinsichtlich der Sicherheit wesentlich verbessert werden.

Durch eine der vorgenannten Schaltungsanordnungen wie auch durch das vorgenannte Verfahren kann der Aufwand bei der Überprüfung deutlich verringert werden.

Die Überprüfungen können bei Schaltern oder Tastern beliebig oft und jederzeit ohne die Notwendigkeit einer manuellen Betätigung durch Aufruf der Software-Prüfroutine durchgeführt werden. Dies kann neben Tests in der Produktion auch beim Kundendienst angewendet werden.

Der Prüfrechner wird nur noch zum Anstoß der Prüfroutinen und zum Auslesen der Fehlerspeicher/Statusbits verwendet.

Ein Ausführungsbeispiel der Erfindung ist in der Zeichnung dargestellt. Es zeigt dabei im einzelnen:
- Fig. 1:: ein erstes Beispiel mit einem Wechselschalter,
- Fig. 2:: eine Darstellung des Zeitverlaufes des Signalpegels bei der Überprüfung,
- Fig. 3:: ein Beispiel eines analogcodierten Schalters,
- Fig. 4:: ein weiteres Beispiel eines Schalters,
- Fig. 5:: ein Ausführungsbeispiel eines Schalters entsprechend der Erfindung,
- Fig. 6:: eine Darstellung des Zeitverlaufes des Signalpegels bei der Überprüfung und
- Fig. 7:: ein weiteres Beispiel eines Schalters.

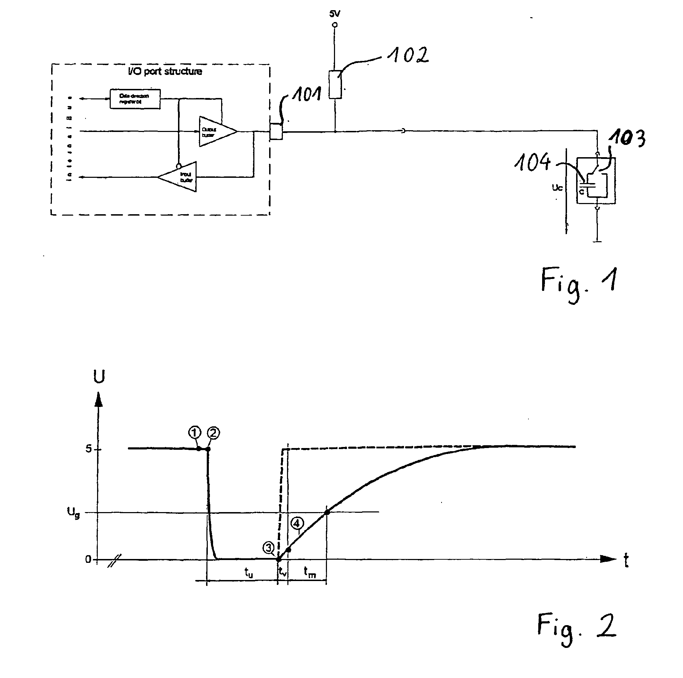

Figur 1 zeigt das prinzipielle Blockschaltbild eines Controller-I/O-Ports 101 mit der notwendigen Beschaltung 102 (Widerstand R) zum Einlesen eines Schalters 103. Dieser Schalter 103 ist als Wechselschalter ausgebildet, dessen eine Schaltstrecke den I/O-Port 101 auf Masse kurzschließt und über dessen andere Schaltstrecke der I/O-Port über eine Kondensatoranordnung 104, die in dem Beispiel der Figur 1 aus einem einzigen Kondensator besteht, mit Masse verbunden wird. Die einzige Änderung, die der Schalter 103 benötigt, ist ein Kondensator 104, der in der Ruhestellung (unbetätigten Stellung) des Schalters 103 integriert wird. Mit den hohen Taktraten der Controller ist es möglich, schnelle Ladevorgänge am I/O-Port 101 einzulesen, so daß hier ein sehr kleiner Kondensator 104 in Frage kommt (Ladezeit proportional zu C), der platzmäßig bei der Unterbringung in dem Schalter 103 keine Rolle spielen dürfte. Der Widerstand R, der bei Push/Pull- und Open-Drain-Ausgangsstufen vorhanden sein muß, um einen definierten Ruhestellungs-Pegel (hier 5V) für die Eingangsstufen zur Verfügung zu stellen, kann bei Ausgangsstufen mit Kollektorwiderstand entfallen. Selbstverständlich kann der Schalter 103 auch als Taster ausgeführt sein. Durch die Ausbildung als Wechselschalter bzw. Wechseltaster wird der Kondensator bei einer Betätigung des Schalters oder Tasters nicht entladen. Dadurch wird vorteilhaft der Energieverbrauch eingeschränkt und zum anderen die Schaltgeschwindigkeit erhöht, weil der Schaltvorgang sofort erkannt werden kann und nicht erst nach der Zeit, die benötigt wird, um den Kondensator zu entladen. In der unbetätigten Stellung des Schalters oder Tasters zieht der Kondensator keinen Ruhestrom. Dies ist vor allem bei Anwendungen im Automobilbereich sehr wichtig, um die Batterie nicht unnötig belasten zu müssen.

Der Controller muß für eine Potentialänderung am Kondensator sorgen und dann prüfen, ob diese Potentialänderung in der Anfangszeit des Umladevorgangs des Kondensators am I/O-Port anliegt. Ohne Kondensator 104 bzw. Schalter 103 schnappt das Potential gleich in die Ausgangslage zurück. Figur 2 zeigt den Zeitverlauf des Signalpegels bei der Überprüfung am I/O-Port. Der Schalter 103 nach Figur 1 befindet sich in unbetätigter Stellung. Ein herkömmlicher Schalter, bzw. ein nicht eingebauter Schalter würde den gestrichelt dargestellten Zeitverlauf zeigen.

Die in der Figur 2 markierten Punkte haben im einzelnen folgende Bedeutung:
1) erster Zeitpunkt, an dem der I/O-Port eingelesen wird
2) Umschaltung des I/O-Ports auf "Ausgang" und Ausgabe von "NULL"
3) Umschaltung des I/O-Ports auf "Eingang"
4) Zweiter Zeitpunkt, an dem der I/O-Port eingelesen wird.

Nach dem Anschließen des Schalters 103 fließt Strom über den Widerstand R in den Kondensator 104 und lädt diesen auf U_{c} = 5V auf. Danach sperrt der Kondensator 104 und befindet sich im Ruhezustand, d.h. es fließt kein Ruhestrom. Auch bei Betätigung des Schalters 103 bleibt der Kondensator 104 geladen, da er keine Möglichkeit hat, sich zu entladen. Eventuelle Pegeländerungen bzw. Zeitverzögerungen am I/O-Port 101 treten bei Umschaltaktionen dieses Schalters 103 nicht auf.

Im Verlaufe einer Überprüfung wird entsprechend der Darstellung der Figur 2 als erstes der I/O-Port 101 des zu prüfenden Schalters 103 eingelesen (Zeitpunkt 1), um evtl. zu erkennen, ob ein Leitungsfehler (Schluß gegen GND) vorliegt oder der Schalter/Taster betätigt wird. Da sich der testbare Schalter 103 vor der Überprüfung in der Ruhestellung befinden sollte, liegt ein Schluß gegen GND vor, falls zum Zeitpunkt 1 der I/O-Port mit "Low" eingelesen wird.

Der Umschaltvorgang zum Zeitpunkt 2 (Umschaltung von "Eingang" auf "Ausgang" und Ausgabe von "Low") sorgt für die Entladung des Kondensators über den I/O-Port. Die Zeit tᵤ sollte so groß gewählt werden, daß der Kondensator sich voll entlädt (Entladezeit tᵤ = 5*R'*C; R': Kontakt- und Leitungswiderstand).

Nach der Zeit tᵤ wird der I/O-Port wieder auf Eingang geschaltet (Zeitpunkt 3). Der Kondensator beginnt, sich über den Widerstand R aufzuladen, bis er wieder die Spannung U_{c} = 5V und somit den Ruhezustand erreicht (Aufladezeit = 5*R*C).

Um sicherzustellen, daß das Einlesen des I/O-Port 101 nicht in den Umschaltvorgang des I/O-Ports 101 fällt, wird die Verzögerungszeit tᵥ abgewartet, bis der I/O-Port 101 eingelesen wird.

Der Pegel wird dann mit einem Schwellwert U_{g} verglichen. Liegt der Pegel unter diesem Schwellwert, so kann geschlossen werden, daß ein Schalter 103 eingebaut und richtig kontaktiert ist. Liegt der Pegel über diesem Schwellwert, kann geschlossen werden, daß der gestrichelt gezeichnete Zeitverlauf vorliegt und also kein Schalter 103 eingebaut ist oder der Schalter 103 nicht richtig kontaktiert ist.

Die Zeit tₘ steht zur Verfügung, um den I/O-Port einzulesen. Alles, was nach dieser Zeit tₘ eingelesen wird, kann nicht mehr richtig interpretiert werden. Nach der Zeit tₘ würde das Einlesen des I/O-Port auch bei dem eingebauten testbaren Schalter "High" ergeben und somit für die Auswertung - Schalter eingebaut oder nicht - eine falsche Information liefern. Während der Zeit tₘ wird dagegen am I/O-Port bei dem eingebauten testbaren Schalter "Low" und bei fehlendem Schalter "High" eingelesen. Eine Eindeutigkeit ist damit nur während der Zeit tₘ sichergestellt.

In der nachfolgenden Tabelle sind die möglichen Fälle der zwei Zeitpunkte, an dem der I/O-Port des Schalters 103 eingelesen wird, mit den daraus zu gewinnenden Erkenntnissen aufgeführt.

| Zeitpunkt 1 | Zeitpunkt 4 | Erkenntnis |
|---|---|---|
| "Low" | "Low" | (Schalter betätigt) oder Schluß an GND |
| "Low" | "High" | kommt nicht vor |
| "High" | "Low" | Schalter eingebaut |
| "High" | "High" | Schalter nicht eingebaut oder Schluß an V_{cc} |

Schalter oder Taster, die nicht wie der in Figur 1 dargestellte Schalter 103 auf Masse sondern auf 12V liegen, können nach dem gleichen Verfahren getestet werden. Es kehrt sich lediglich die Logik des I/O-Ports um, so daß statt dem Entladen des Kondensators auf Masse der Kondensator auf 5V geladen wird.

Bei komplexen Schaltern mit mehreren Signalleitungen sollte jede Leitung, die vom Controller eingelesen wird, mit einem Kondensator versehen werden, um prüfen zu können, ob alle Leitungen ordnungsgemäß vorhanden sind.

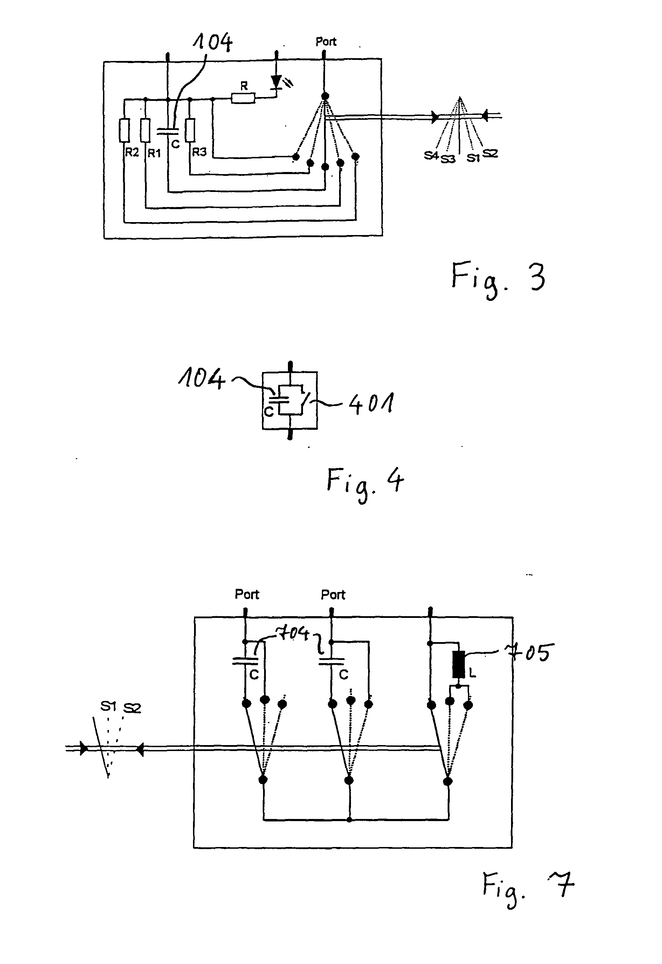

Der in Figur 3 dargestellte analogcodierte Fensterheberschalter zeigt, daß im Prinzip alle Schalter/Taster auf diese Art zu einem testbaren Schalter/Taster gemacht werden können.

Da analogcodierte Schalter über ein Port mit A/D-Wandler eingelesen werden müssen und diese meistens nur als Eingabeports ausgelegt sind, muß hier allerdings zusätzlich noch ein I/O-Port verwendet werden, um die Umladung des Kondensators 104 zu ermöglichen. Der eigentliche Ablauf der Überprüfung ist dann genauso wie oben beschrieben.

Figur 4 zeigt ein weiteres Beispiel eines Schalters, falls der Aufwand für die Erstellung des testbaren Schalters momentan zu kurzfristig ist oder der Aufwand sich wegen des Auslaufens eines bestimmten Schalters nicht mehr lohnt. Nach diesem Ausführungsbeispiel kann der Kondensator 104 auch extern am Schalter 401 angebracht werden. Vorteilhaft ist der Kondensator 104 am Schalter 401 und nicht im Stecker des Schalters 401 angebracht. Bei diesem Schalter 401 besteht der Nachteil darin, daß manuelle Schalterbetätigungen beim Übergang in die "Aus"-Stellung während des Betriebes etwas verzögert erkannt werden. Das liegt am Kondensator 104, der sich bei jedem Schaltvorgang entlädt und dann wieder auflädt. Der Controller erkennt die Änderung der Schalterstellung um diese Umladephase später. Diese Verzögerung liegt je nach der Dimensionierung des Kondensators 104 im ms/µs-Bereich, so daß dieser Effekt vernachlässigbar ist, da der Benutzer dies nicht merkt.

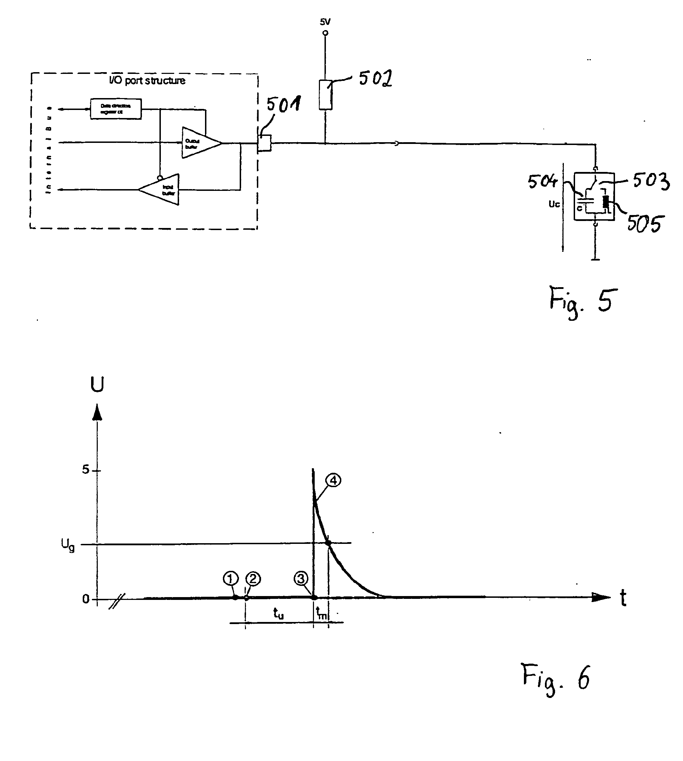

Figur 5 zeigt ein Ausführungsbeispiel eines Schalters entsprechend der Erfindung. Dieses prinzipielle Blockschaltbild zeigt ein Controller-I/O-Port 501 mit der notwendigen Beschaltung 502 (Widerstand R) zum Einlesen eines Schalters 503 dargestellt. Dieser Schalter 503 ist neben dem Kondensator 504 in der einen Schaltrecke, der in der Ruhestellung (unbetätigten Stellung) des Schalters/Tasters integriert wird, mit einer Spule 505 versehen, die in die andere Schaltstrecke eingefügt ist, so daß sie in der betätigten Stellung integriert wird. Der Widerstand R, der bei Push/Pull- und Open-Drain-Ausgangsstufen vorhanden sein muß, um einen definierten Ruhestellungs-Pegel (hier 5V) für die Eingangsstufen zur Verfügung zu stellen, kann bei Ausgangsstufen mit Kollektorwiderstand entfallen.

Erfindungsgemäß kann dieser Schalter 503 auch in der betätigten Stellung durch einen Prozessor/Controller getestet werden. Es kann unterschieden werden, ob der Schalter 503, der gegen Masse schaltet, geschlossen ist oder ob ein Schluß gegen GND vorliegt und dadurch der Controllereingang auf Masse liegt.

Bei den Schaltern nach den bisherigen Ausführungsbeispielen kann dies nur unterschieden werden, falls sich der Schalter vor dem Test in der Ruhestellung befindet und der Controllereingang auf Masse liegt, da dann nur ein Schluß gegen Masse in Frage kommt.

Mittels der Spule kann also eine Überprüfung auch dann erfolgen, wenn der Schalter eingeschaltet ist bzw. wenn der Taster betätigt wird.

Dies wirkt sich insbesondere bei komplexen Einheiten wie beispielsweise in der Automobilindustrie oder der Elektronikindustrie aus, weil die Schalter nicht zuerst in die Ruhestellung geschaltet werden müssen bevor die Überprüfung gestartet werden kann. Die Überprüfung kann vielmehr in jeder Schalterstellung erfolgen.

Vorteilhaft kann diese Überprüfung auch während des laufenden Betriebes durchgeführt werden, um insbesondere bei sicherheitsrelevanten Funktionen prüfen zu können, ob der Schalter auch wirklich betätigt ist und nicht zufällig ein Schluß gegen GND vorliegt.

Figur 6 zeigt den Signalverlauf am I/O-Port 501 beim Ablauf der Überprüfung des Schalters 503 in der betätigten Stellung. Bei einem betätigten herkömmlichen Schalter, bzw. einem Schluß gegen Masse würde sich der gestrichelte Verlauf ergeben. Durch die Potentialänderung am I/O-Port beim Prüfablauf kann beim Schalter 503 unterschieden werden, ob sich der Schalter in der betätigten Stellung befindet und damit ordnungsgemäß funktioniert oder ein Schluß gegen Masse vorliegt.

Die in der Figur 6 markierten Punkte haben im einzelnen folgende Bedeutung:
1) erster Zeitpunkt, zu dem der I/O-Port gelesen wird,
2) Umschaltung des I/O-Ports auf "Ausgang" und Ausgabe von NULL
3) Umschaltung des I/O-Ports auf "Eingang"
4) Zweiter Zeitpunkt, zu dem der I/O-Port eingelesen wird.

In der betätigten Stellung des Schalters 503 fließt Strom durch die Spule 505 und erzeugt einen Spannungsabfall, der aufgrund des kleinen Leitungswiderstandes der Spule 505 im Vergleich mit dem viel größeren Widerstand R annähernd Null ist, so daß der Controller hier auch mit der Spule 505 im eingeschwungenen Zustand "Low" einliest.

In dem Ablauf der Überprüfung nach Figur 6 wird als erstes der I/O-Port des zu überprüfenden Schalters 503 eingelesen (Zeitpunkt 1), um zu erkennen, ob sich der Schalter 503 in der betätigten Stellung befindet oder nicht. Die Fälle Schluß an Vcc/Gnd und Unterbrechung können in Verbindung mit dem zweiten Einlesen des I/O-Portes (Zeitpunkt 4) ausgeschlossen werden.

Der Umschaltvorgang zum Zeitpunkt 2 (Umschaltung von "Eingang" auf "Ausgang" und Ausgabe von "Low") sorgt dafür, daß der Strom nicht mehr über die Spule 505 des Schalters 503 abfließt, sondern über den I/O-Port 501 des Controllers. Die Zeit tᵤ sollte so groß gewählt werden, daß sich das Magnetfeld der Spule 505 abbaut (tᵤ ≈ 5*L/R'; R': Kontakt- und Leitungswiderstand).

Nach der Zeit tᵤ wird der I/O-Port 501 wieder auf Eingang geschaltet (Zeitpunkt 3). Der Strom ist nun wieder bestrebt, über die Spule 505 abzufließen. Da die Spule 505 im ersten Moment einen sehr hohen Widerstand hat, fällt fast die ganze Spannung an der Spule 505 ab (Spannungsteiler bestehend aus dem Widerstand R und dem Widerstand der Spule L des Schalters 503), so daß der Controllereingang eine Spannung von ≈5V sieht. Anschließend wird der Widerstand der Spule 505 immer kleiner, so daß die Spannung am Controllereingang entsprechend einer e-Funktion innerhalb der Zeit ≈5*L/R abgebaut wird und bei ≈0V den Ruhezustand erreicht.

Die Zeit tₘ steht zur Verfügung, um den I/O-Port einzulesen. Alles was nach dieser Zeit tₘ eingelesen wird, kann nicht mehr richtig interpretiert werden, denn nach der Zeit tₘ würde das Einlesen des I/O-Port nur den statischen Zustand des Schalters liefern, da die Grenzspannung U_{g} zwischen der "High"- und "Low"-Erkennung wieder unterschritten ist. Während der Zeit tₘ wird dagegen am I/O-Port 501 bei dem eingebauten Schalter 503 "High" und bei einem Schluß gegen Masse "Low" eingelesen. Eine Eindeutigkeit ist damit nur während der Zeit tₘ sichergestellt.

In der nachfolgenden Tabelle sind die möglichen Fälle der zwei Zeitpunkte, zu denen der I/O-Port 501 des Schalters 503 eingelesen wird, mit den daraus zu gewinnenden Erkenntnissen aufgeführt.

| Zeitpunkt 1 | Zeitpunkt 4 | Erkenntnis |
|---|---|---|
| "Low" | "Low" | Schluß an GND |
| "Low" | "High" | Schalter betätigt |
| "High" | "Low" | Schalter eingebaut |
| "High" | "High" | Schalter nicht eingebaut oder Schluß an V_{cc} |

Im Gegensatz zur oben dargestellten Tabelle sind die ersten beiden Zeilen in der Tabelle 2 eindeutig bestimmt. Die vierte Zeile muß hier nicht näher unterschieden werden, da der Pfad des Schalters defekt ist und die zu überprüfende Einheit ohnehin in die Nacharbeit muß.

Es muß noch unterschieden werden, ob die Überprüfung nach Figur 2 (Prüfung: Signalpegel kleiner als Schwellwert) oder nach Figur 6 (Prüfung: Signalpegel größer als Schwellwert) erfolgen soll. Dies kann erfolgen, indem der Signalpegel zum Zeitpunkt 1 ausgewertet wird. Wenn der Signalpegel zu diesem Zeitpunkt auf Masse liegt, erfolgt die Auswertung nach Figur 6, andernfalls nach Figur 2. Ebenso könnte der Signalpegel noch zu einem späteren Zeitpunkt untersucht werden, um zu prüfen, ob der Schwellwert über- bzw. unterschritten wurde. Auch damit wäre eine Überprüfung möglich.

Es ist dabei ersichtlich, daß die Überprüfung gemäß Figur 6 möglich ist, wenn sich der Schalter im geschlossenen Zustand befindet. Es ist also auch ein Aufbau des Schalters denkbar, bei dem lediglich in der Schaltstrecke eine Spule eingebracht ist, d.h. also daß ein solcher Schalter keinen Kondensator aufweist. Ein solcher Schalter kann dann nur im eingeschalteten Zustand geprüft werden.

Eine Überprüfung des Schalters ist auch im laufenden Betrieb möglich, um ein Schalten des Schalters von einem Masseschluß unterscheiden zu können. Bei einem Masseschluß kommt es nämlich zu dem gestrichelt gezeichneten Verlauf des Signalpegels in der Figur 6. Wenn also das in Figur 6 gezeigte und in der Auswertung beschriebene charakteristische Zeitverhalten erkannt wird, kann darauf geschlossen werden, daß der Schalter eingeschaltet ist.

Bei komplexen Schaltern mit mehreren Signalleitungen wird nur eine Spule gebraucht, wenn der Schalter gemäß Figur 7 aufgebaut wird.

Jede Signalleitung ist bei diesem Schalter mit einem Kondensator 704 versehen, um beim unbetätigten Schalter prüfen zu können, ob alle Leitungen ordnungsgemäß vorhanden sind. Diese Kondensatoren können auch entfallen, wenn die Spule 705 vorhanden ist und der Schalter nur im geschalteten Zustand überprüft werden soll. Mit dem Schalter wie dargestellt ist eine Überprüfung sowohl im eingeschalteten wie auch im ausgeschalteten Zustand möglich.

## Patentansprüche

1. Schaltungsanordnung zur Überprüfung der ordnungsgemäßen Kontaktierung eines Schalters oder Tasters in einer gleichspannungsversorgten Schaltung, der zumindest zeitweise mit wenigstens einem Eingang sowie zumindest zeitweise mit wenigstens einem Ausgang eines Controllers oder Mikroprozessors der Schaltungsanordnung zur Überprüfung verbunden ist,
wobei parallel zur Schaltstrecke des Schalters oder Tasters eine Kondensatoranordnung angeordnet ist,
**dadurch gekennzeichnet,**
**daß** in der Schaltstrecke des Schalters oder Tasters eine Spulenanordnung angeordnet ist.

2. Schaltungsanordnung zur Überprüfung der ordnungsgemäßen Kontaktierung eines Schalters oder Tasters in einer gleichspannungsversorgten Schaltung, der zumindest zeitweise mit wenigstens einem Eingang sowie zumindest zeitweise mit wenigstens einem Ausgang eines Controllers oder Mikroprozessors der Schaltungsanordnung zur Überprüfung verbunden ist, wobei der Schalter oder Taster (503) als Wechselschalter oder Wechseltaster ausgebildet ist,
**dadurch gekennzeichnet,**
**daß** dessen eine Schaltstrecke über eine Spulenanordnung (505) mit einem bestimmten Potential verbindet und dessen andere Schaltstrecke über eine Kondensatoranordnung (504) mit dem bestimmten Potential verbindet.

3. Schaltungsanordnung nach einem der Ansprüche 1 bis 2,
**dadurch gekennzeichnet, daß** Eingang und Ausgang (101) des Controllers oder Mikroprozessors über ein I/O-Port realisiert sind.

4. Schaltungsanordnung nach einem der Ansprüche 1 bis 2,
**dadurch gekennzeichnet, daß** Eingang und Ausgang des Controllers oder Mikroprozessors verschieden und zeitversetzt aktivierbar sind.

5. Verfahren zum Prüfen der ordnungsgemäßen Kontaktierung eines Schalters oder Tasters mit einer der Schaltungsanordnungen nach einem der Ansprüche 1 bis 4,
**dadurch gekennzeichnet, daß** während des Betriebes bei einem erkannten Signalpegel, der auf eine Betätigung des Schalters oder Tasters zurückgeführt werden kann, über den Ausgang ein Signalpegel ausgegeben wird, der dem Signalpegel am Eingang bei einer ordnungsgemäßen Kontaktierung und einer Betätigung des Schalters oder Tasters entspricht, und anschließend der Ausgang deaktiviert wird und daß aus dem Zeitverhalten des Signalpegels darauf geschlossen wird, ob eine ordnungsgemäße Kontaktierung vorliegt.

## Claims

1. Circuit arrangement for checking proper contact-connection of a switch or pushbutton in a circuit supplied with DC voltage, which switch or pushbutton is connected at least temporarily to at least one input and at least temporarily to at least one output of a controller or microprocessor of the circuit arrangement for checking,
a capacitor arrangement being arranged in parallel with the switching path of the switch or pushbutton,
**characterized in that**
a coil arrangement is arranged in the switching path of the switch or pushbutton.

2. Circuit arrangement for checking proper contact-connection of a switch or pushbutton in a circuit supplied with DC voltage, which switch or pushbutton is connected at least temporarily to at least one input and at least temporarily to at least one output of a controller or microprocessor of the circuit arrangement for checking, the switch or pushbutton (503) being formed as a two-way switch or two-way pushbutton,
**characterized in that**
one switching path thereof connects to a specific potential via a coil arrangement (505) and the other switching path thereof connects to the specific potential via a capacitor arrangement (504).

3. Circuit arrangement according to one of Claims 1 to 2,
**characterized in that** the input and output (101) of the controller or microprocessor are realized by means of an I/O port.

4. Circuit arrangement according to one of Claims 1 to 2,
**characterized in that** the input and output of the controller or microprocessor can be activated differently and in temporally offset fashion.

5. Method for testing the proper contact-connection of a switch or pushbutton by means of one of the circuit arrangements according to one of Claims 1 to 4,
**characterized in that** during operation, in the case of an identified signal level which can be attributed to an actuation of the switch or pushbutton, a signal level corresponding to the signal level at the input in the case of proper contact-connection and actuation of the switch or pushbutton is output via the output, and the output is subsequently deactivated, and **in that** the fact of whether proper contact-connection is present is deduced from the time response of the signal level.

## Revendications

1. Arrangement de circuit destiné à contrôler la mise en contact correcte d'un commutateur ou d'un poussoir dans un circuit alimenté en courant continu, lequel est relié au moins par intermittence avec au moins une entrée et au moins par intermittence avec au moins une sortie d'un contrôleur ou d'un microprocesseur de l'arrangement de circuit de contrôle, un arrangement de condensateur étant disposé parallèlement à la branche de commutation du commutateur ou du poussoir, **caractérisé en ce qu'**un arrangement de bobine est disposé dans la branche de commutation du commutateur ou du poussoir.

2. Arrangement de circuit destiné à contrôler la mise en contact correcte d'un commutateur ou d'un poussoir dans un circuit alimenté en courant continu, lequel est relié au moins par intermittence avec au moins une entrée et au moins par intermittence avec au moins une sortie d'un contrôleur ou d'un microprocesseur de l'arrangement de circuit de contrôle, le commutateur ou le poussoir (503) étant réalisé sous la forme d'un commutateur inverseur ou d'un poussoir inverseur, **caractérisé en ce que** l'une de ses branches de commutation établit la liaison avec un potentiel donné par le biais d'un arrangement de bobine (505) et son autre branche de commutation établit la liaison avec le potentiel donné par le biais d'un arrangement de condensateur (504).

3. Arrangement de circuit selon l'une des revendications 1 à 2, **caractérisé en ce que** l'entrée et la sortie (101) du contrôleur du microprocesseur sont réalisées par le biais d'un port d'E/S.

4. Arrangement de circuit selon l'une des revendications 1 à 2, **caractérisé en ce que** l'entrée et la sortie du contrôleur du microprocesseur sont différentes et peuvent être activées avec un décalage dans le temps.

5. Procédé pour contrôler la mise en contact correcte d'un commutateur ou d'un poussoir avec l'un des arrangements de circuit selon l'une des revendications 1 à 4, **caractérisé en ce que** pendant le fonctionnement, en présence d'un niveau de signal reconnu qui peut être attribué à un actionnement du commutateur ou du poussoir, un niveau de signal est délivré par le biais de la sortie, lequel correspond au niveau de signal à l'entrée lorsque la mise en contact est connecte et lors d'un actionnement du commutateur ou du poussoir, et la sortie est ensuite désactivée et que la présence d'une mise en contact correcte est déduite à partir du comportement dans le temps du niveau de signal.
